# EUROPEAN PATENT APPLICATION

(11) **EP 2 634 800 A2**
(43) Date of publication of application: **04.09.2013**
(21) Application number: 13156560.8
(22) Date of filing: 25.02.2013
(51) Int. Cl.: H01L 23/473, H01L 23/373, H01L 23/433

(54) **Cooling device**

(30) Priority: 01.03.2012 JP 2012045892
(71) Applicant: Kabushiki Kaisha Toyota Jidoshokki, Kariya-shi, Aichi 448-8671 (JP)
(72) Inventor: Nishi, Shinsuke, Kariya-shi, Aichi 448-8671 (JP); Mori, Shogo, Kariya-shi, Aichi 448-8671 (JP)
(74) Representative: TBK

(57) **Abstract**

A cooling device includes a main body, a pipe, and a resin portion. The main body includes a first shell plate and a second shell plate each having a peripheral portion. The first shell plate and the second shell plate are integrated together by brazing the peripheral portions, and the main body includes a coolant passage and a port. The pipe is coupled to the main body and allows for circulation of coolant in the coolant passage through the port. The resin portion is molded on an outer surface of the main body at where the pipe is coupled to the main body to fix the pipe to the main body.

## Description

### BACKGROUND OF THE INVENTION

The present invention relates to a cooling device.

Japanese Laid-Open Patent Publication No. 2008-211147 describes a coupling structure for coupling a pipe to a heat exchanger. The coupling structure includes two plates that are pressed and formed in conformance with each other. Each plate includes a peripheral portion and a shallow recess formed by the remaining portion of the plate. The peripheral portion includes a groove, which has a semicircular cross-section and connects the edge of the peripheral portion with the recess. The two plates are stacked so that their recesses face each other and their grooves face each other. A pipe is fitted to the grooves. In this state, the two plates are brazed and fixed to each other so that the plates are in contact with the pipe in a manner impervious to liquids. An annular first protrusion, which is formed along the outer circumference of the pipe, comes in contact with the edge of the entire groove.

In the coupling structure, the pipe may be deformed by heat when brazed. This may result in displacement of the pipe. More specifically, the brazing is performed at, for example, 600°C, at which aluminum components may expand or contract. This may bend the main body of the cooling device and displace the pipe. Further, the heat may deform the pipe.

### SUMMARY OF THE INVENTION

It is an object of the present invention to provide a cooling device that allows for a pipe to be coupled to its main body without being displaced.

To achieve the above object, one aspect of the present invention is a cooling device provided with a main body including a first shell plate and a second shell plate each having a peripheral portion. The first shell plate and the second shell plate are integrated together by brazing the peripheral portions, and the main body includes a coolant passage and a port. A pipe is coupled to the main body. The pipe allows for circulation of coolant in the coolant passage through the port. A resin portion is molded on an outer surface of the main body at where the pipe is coupled to the main body to fix the pipe to the main body.

Other aspects and advantages of the present invention will become apparent from the following description, taken in conjunction with the accompanying drawings, illustrating by way of example the principles of the invention.

### BRIEF DESCRIPTION OF THE DRAWINGS

Fig. 1A is a front view of an inverter module according to one embodiment of the present invention;
Fig. 1B is a plan view of the inverter module shown in Fig. 1A;
Fig. 2A is a front view of the inverter module shown in Fig. 1A in a state in which a resin portion is eliminated;
Fig. 2B is a plan view of the inverter module shown in Fig. 1A in a state in which the resin portion is eliminated;
Fig. 3 is a cross-sectional view showing the inverter module of Fig. 1A where a pipe is coupled;
Fig. 4 is a circuit diagram of the inverter module shown in Fig. 1A;
Fig. 5A is a front view showing a main body and insulating substrates of the cooling device of Fig. 1A;
Fig. 5B is a plan view showing the main body and insulating substrates of the cooling device of Fig. 1A;
Fig. 6 is a cross-sectional view taken along VI-VI in Fig. 5B;
Fig. 7A is a front view illustrating a manufacturing process of the inverter module;
Fig. 7B is a plan view showing the inverter module of Fig. 7A;
Fig. 8A is a front view illustrating a manufacturing process of the inverter module;
Fig. 8B is a plan view showing the inverter module of Fig. 8A;
Fig. 9 is a cross-sectional view showing the inverter module of Fig. 1A where a pipe is coupled and illustrating a manufacturing process of the inverter module;
Fig. 10 is a front view showing the inverter module;
Fig. 11 is a front view showing the inverter module;
Fig. 12 is a front view showing the inverter module;
Fig. 13 is a cross-sectional view showing a modification of an inverter module where a pipe is coupled;
Fig. 14 is a partial cross-sectional view showing a modification of an inverter module;
Fig. 15A is a partial cross-sectional view showing a modification of an inverter module;
Fig. 15B is a partial side view showing the inverter module of Fig. 15A;
Fig. 16A is a partial cross-sectional view showing a modification of an inverter module; and
Fig.-16B is a partial side view showing the inverter module of Fig. 16A.

### DETAILED DESCRIPTION OF THE INVENTION

A vehicle inverter according to one embodiment of the present invention will now be described with reference to the drawings.

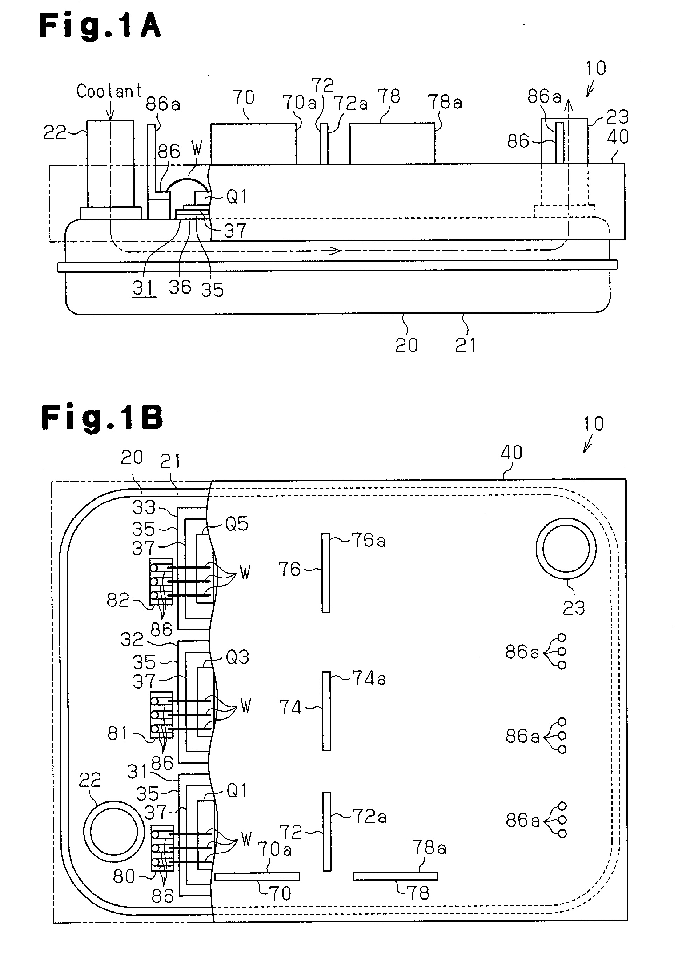

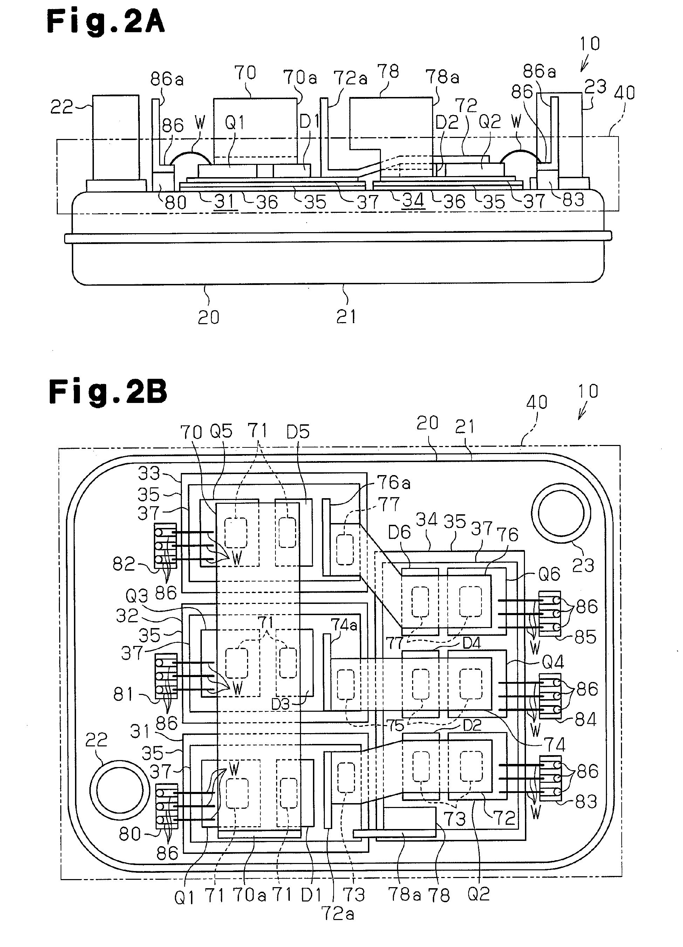

Referring to Figs. 1A and 1B, an inverter module 10 includes a cooling device. The inverter module 10 is resin-molded and includes substrates on which semiconductor elements (chips) are mounted. As shown in Figs. 1A to 2B, the inverter module 10 includes a water-cooling type cooling device 20, four insulating substrates 31, 32, 33 and 34, six transistors (chips) Q1, Q2, Q3, Q4, Q5, and Q6, six diodes (chips) D1, D2, D3, D4, D5, and D6, and a molded resin portion 40. The resin portion 40 may be formed from, for example, epoxy resin.

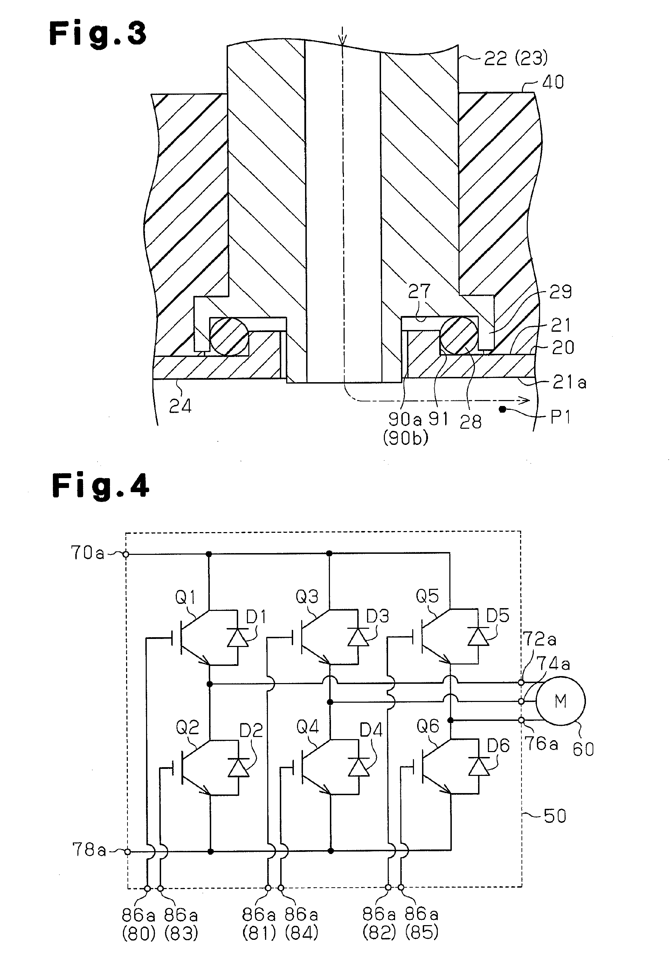

Fig. 4 shows the circuit configuration of the inverter module 10. The inverter module 10 includes an inverter 50, which converts DC power supplied from an external device, to AC power. Then, the inverter 50 supplies the AC power to a travel motor 60. This drives the motor 60, which produces rotation.

In detail, the inverter 50 includes a plurality of arms, namely, a U-phase arm, a V-phase arm, and a W-phase arm arranged in parallel between a power supply line and a ground line. The arms include two series-connected transistors (IGBT) Q1 and Q2, Q3 and Q4, and Q5 and Q6, respectively. Diodes D1, D2, D3, D4, D5, and D6 are arranged between the collector and emitter of the transistors Q1, Q2, Q3, Q4, Q5, and Q6, respectively. Each diode allows for current to pass from the emitter to the collector of the corresponding transistor.

As shown in Figs. 1A to 2B, the insulating substrates 31, 32, 33, and 34 are formed by direct brazed aluminum (DBA) substrates. Each DBA substrate includes a ceramic substrate 35, an aluminum layer 36, which is formed on a first surface of the ceramic substrate 35, and an aluminum layer 37, which is formed on a second surface of the ceramic substrate 35. The aluminum layer 36 is patterned on the first surface of the ceramic substrate 35. In the same manner, the aluminum layer 37 is patterned on the second surface of the ceramic substrate 35.

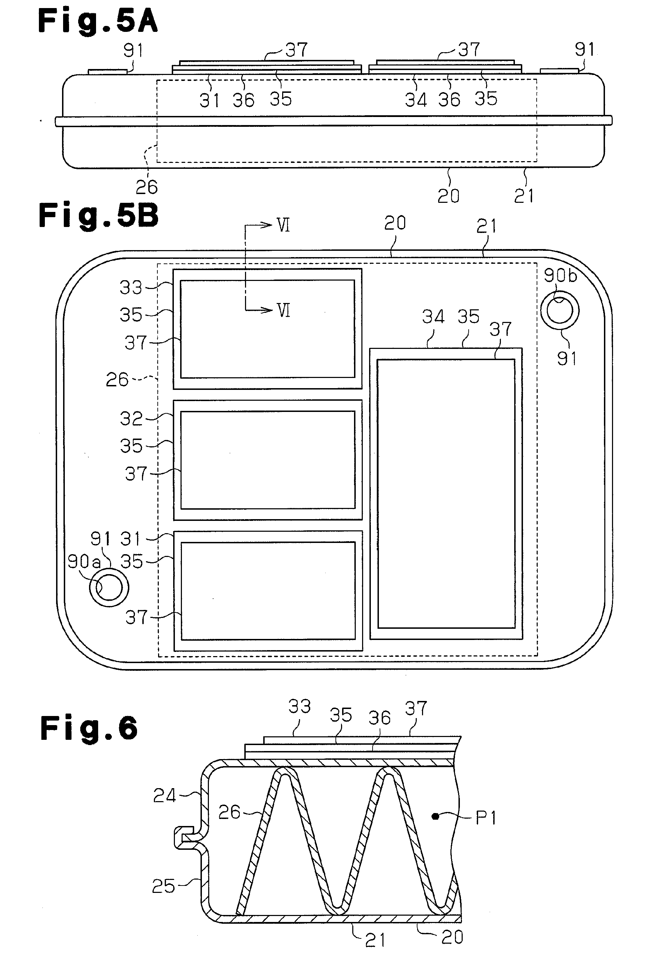

The cooling device 20 includes a main body 21, which is a tetragonal box having a low profile, a resin inlet pipe 22, and a resin outlet pipe 23. The main body 21 of the cooling device 20 is formed from aluminum. As shown in Fig. 6, the main body 21 includes an upper plate 24, which functions as a first shell plate, a lower plate 25, which functions as a second shell plate, and inner fins 26, which are undulated. A peripheral portion of the upper plate 24 and a peripheral portion of the lower plate 25 are swaged together. In this state, the peripheral portions of the upper plate 24 and the lower plate 25 are brazed to each other. This brazes the upper plate 24 and the lower plate 25 at their peripheral portions in the main body 21. The inner fins 26 are also brazed to and between the upper plate 24 and lower plate 25.

The main body 21 includes a coolant passage P1 (refer to Figs. 3 and 6). The inlet pipe 22 is coupled to the upper surface of the main body 21 and allows for coolant to be supplied into the main body 21 through a first port 90a (refer to Figs. 5A and 5B), which is formed in the main body 21. In the same manner, the outlet pipe 23 is coupled to the upper surface of the main body 21 and allows for coolant to be discharged from the main body 21 through a second port 90b (refer to Figs. 5A and 5B), which is formed in the main body 21. More specifically, a pump sends coolant into the main body 21 through the inlet pipe 22 and discharges the coolant from the main body 21 through the outlet pipe 23.

As described above, the pipes 22 and 23 allows for coolant to circulate through the ports 90a and 90b, which are formed in the main body 21.

The insulating substrates 31, 32, 33, and 34, on which the transistors (chips) Q1 to Q6 and the diodes (chips) D1 to D6 functioning as semiconductor elements are mounted, are brazed to the surface of the main body 21. In detail, the four insulating substrates 31, 32, 33, and 34 are brazed and joined with the upper surface of the main body 21 of the cooling device 20. That is, the aluminum layer 36 under the ceramic substrate 35 in each of the four insulating substrates 31, 32, 33, and 34 is brazed and joined with the upper surface of the cooling device 20.

The aluminum layer 37 on the ceramic substrate 35 in the insulating substrate 31 is a wiring material. The transistor (chip) Q1 and the diode (chip) D1 are soldered and joined with the upper surface of the aluminum layer 37. The aluminum layer 37 on the ceramic substrate 35 in the insulating substrate 32 is a wiring material. The transistor (chip) Q3 and the diode (chip) D3 are soldered and joined with the upper surface of the aluminum layer 37. The aluminum layer 37 on the ceramic substrate 35 in the insulating substrate 33 is a wiring material. The transistor (chip) Q5 and the diode (chip) D5 are soldered and joined with the upper surface of the aluminum layer 37. The aluminum layer 37 on the ceramic substrate 35 in the insulating substrate 34 is a wiring material. The transistors (chips) Q2, Q4, and Q6 and the diodes (chips) D2, D4, and D6 are soldered and joined with the upper surface of the aluminum layer 37.

The collector terminals on the upper surfaces of the transistors Q1, Q3, and Q5 and the cathode terminals on the upper surfaces of the diodes D1, D3, and D5 are joined with a conductive plate 70, which functions as an external connection terminal, by solder 71. The collector terminal on the upper surface of the transistor Q2, the cathode terminal on the upper surface of the diode D2, and the aluminum layer 37 in the insulating substrate 31 (the emitter of the transistor Q1 and the anode of the diode D1) are joined with a conductive plate 72, which functions as an external connection terminal, by solder 73. Further, the collector terminal on the upper surface of the transistor Q4, the cathode terminal on the upper surface of the diode D4, and the aluminum layer 37 in the insulating substrate 32 (i.e., the emitter of the transistor Q3 and the anode of the diode D3) are joined with a conductive plate 74, which functions as an external connection terminal, by solder 75. The collector terminal on the upper surface of the transistor Q6, the cathode terminal on the upper surface of the diode D6, and the aluminum layer 37 in the insulating substrate 33 (i.e., the emitter of the transistor Q5 and the anode of the diode D5) are joined with a conductive plate 76, which functions as an external connection terminal, by solder 77. A conductive plate 78, which functions as an external connection terminal, is soldered to the aluminum layer 37 on the ceramic substrate 35 in the insulating substrate 34. The conductive plates 70, 72, 74, 76, and 78 are formed from copper. The conductive plates 70, 72, 74, 76, and 78 each include a first end a second end. The first ends of the conductive plates 70, 72, 74, 76, and 78 are electrically connected to the corresponding transistors Q1, Q2, Q3, Q4, Q5, and Q6 and the corresponding diodes D1, D2, D3, D4, D5, and D6.

The second end of the conductive plate 70 is bent upward. In the same manner, the second end of the conductive plate 72 is bent upward. The second end of the conductive plate 74 is bent upward. The second end of the conductive plate 76 is bent upward. The second end of the conductive plate 78 is bent upward.

Six connection pin seats 80, 81, 82, 83, 84, and 85 are fixed to the upper surface of the main body 21 of the cooling device 20. Three connection pins 86, which function as external connection terminals, are fixed to each of the connection pin seats 80, 81, 82, 83, 84, and 85. The connection pins 86 are formed from copper. One of the three connection pins 86 forms a gate voltage application line, and the two remaining connection pins 86 forming an emitter voltage detection line and an emitter temperature detection line. The three connection pins 86 include first terminals electrically connected by wires W formed by a wiring material, or wire-bonded, to the transistors (chips) Q1, Q2, Q3, Q4, Q5, and Q6.

The three connection pins 86 include the first terminals, which are electrically connected to the corresponding transistors Q1, Q2, Q3, Q4, Q5, and Q6, and second terminals, which are bent upward.

The resin portion 40 covers the components arranged on the upper surface of the main body 21 of the cooling device 20 (i.e., the insulating substrates 31, 32, 33, and 34, the transistors Q1, Q2, Q3, Q4, Q5, and Q6, the diodes D1, D2, D3, D4, D5, and D6, the conductive plates 70, 72, 74, 76, and 78, the connection pins 86, and the wire W). The conductive plates 70, 72, 74, 76, and 78 include upright portions 70a, 72a, 74a, 76a, and 78a with upper ends exposed from the resin portion 40. In the same manner, the three connection pins 86, which are connected to each of the transistors Q1, Q2, Q3, Q4, Q5, and Q6, include upright portions 86a with upper ends exposed from the resin portion 40.

The portion where the inlet pipe 22 is coupled to the main body 21 of the cooling device 20 and the portion where the outlet pipe 23 is coupled to the main body 21 are formed as shown in Fig. 3.

As shown in Fig. 3, the main body 21 has a top panel 21a, which includes the first port 90a and the second port 90b, and a positioning part 91, which projects upward and entirely around each of the first port 90a and second port 90b. The inlet pipe 22 and the outlet pipe 23 each have a thick lower end, which includes a recess 27 open downward and extending along the entire circumference of the pipe. The main body 21 closes the opening of the recess 27. The positioning part 91 is arranged in the recess 27. An O-ring 28 is set in the recess 27.

The resin portion 40 fixes the main body 21 of the cooling device 20 with the inlet pipe 22 and the outlet pipe 23. The O-ring 28 is in close contact with the top panel 21a of the main body 21 and also with the bottom surface of the recess 27. As a result, the main body 21 and the inlet pipe 22 are in contact with each other in a manner impervious to liquid, and the main body 21 and the outlet pipe 23 are also in contact with each other in a manner impervious to liquid. Also, the positioning part 91, which positions the O-ring 28 relative to the main body 21, is formed on the main body 21 where the inlet pipe 22 is coupled to the main body 21 and where the outlet pipe 23 is coupled to the main body 21. Further, a positioning part 29, which positions the O-ring 28 relative to the main body 21, is formed on the inlet pipe 22 and the outlet pipe 23 where the inlet pipe 22 is coupled to the main body 21 and where the outlet pipe 23 is coupled to the main body 21. The positioning part 91 positions the O-ring 28 from a radially inner side, and the positioning part 29 positions the O-ring 28 from a radially outer side.

The operation of the inverter module 10 will now be described.

Coolant is supplied to the inlet pipe 22 of the cooling device 20. The coolant enters the main body 21 of the cooling device 20 through the inlet pipe 22. The coolant flows through the main body 21 of the cooling device 20 toward the outlet pipe 23. Then, the coolant enters the outlet pipe 23 to be discharged from the outlet pipe 23. The six transistors Q1, Q2, Q3, Q4, Q5, and Q6 of the inverter module 10 each generate heat when undergoing a switching operation. The six diodes D1, D2, D3, D4, D5, and D6 generate heat when activated. The heat generated by the transistors Q1, Q2, Q3, Q4, Q5, and Q6 is transferred to the main body 21 of the cooling device 20 through the insulating substrates (DBA substrates) 31, 32, 33, and 34, which transfer heat to the coolant flowing through the main body 21 of the cooling device 20. In the same manner, the heat generated by the six diodes D1, D2, D3, D4, D5, and D6 is transferred to the main body 21 of the cooling device 20 through the insulating substrates (DBA substrates) 31, 32, 33, and 34, which transfer heat to the coolant flowing through the main body 21 of the cooling device 20.

A method for manufacturing the inverter module 10 will now be described with reference to Figs. 1A to 3 and Figs. 5A to 9.

Referring to Figs. 5A to 6, the insulating substrates (DBA substrates) 31, 32, 33, and 34 are prepared. The aluminum layer 36 is patterned on one surface of the ceramic substrate 35, and the aluminum layer 37 is patterned on the other surface of the ceramic substrate 35. The peripheral portions of the upper plate 24 and lower plate 25, which form the main body 21 of the cooling device 20, are swaged and brazed together. Further, the undulated inner fins 26 are also brazed between the upper plate 24 and the lower plate 25. At the same time, the insulating substrates (DBA substrates) 31, 32, 33, and 34 are brazed to the upper surface of the main body 21 of the cooling device 20. In detail, the aluminum layer 36 under the ceramic substrate 35 in each of the four insulating substrates 31, 32, 33, and 34 is brazed to the upper surface of the cooling device 20. The brazing is performed at about 600°C. This integrates the main body 21 of the cooling device with the insulating substrates 31, 32, 33, and 34.

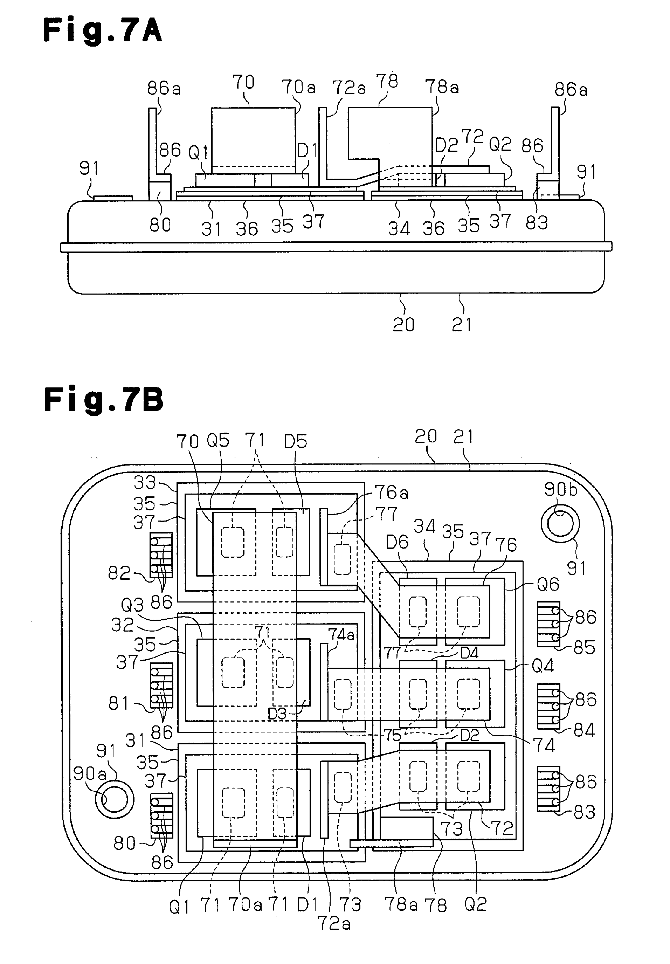

Subsequently, referring to Figs. 7A and 7B, each of the transistors Q1, Q2, Q3, Q4, Q5, and Q6 and each of the diodes D1, D2, D3, D4, D5, and D6 are soldered to the upper surface of the aluminum layer 37 on the ceramic substrate 35 in the corresponding one of the insulating substrates 31, 32, 33, and 34.

At the same time, the conductive plates 70, 72, 74, 76, and 78 are soldered to the transistors Q1, Q2, Q3, Q4, Q5, and Q6 and the diodes D1, D2, D3, D4, D5, and D6. Further, the connection pin seats 80, 81, 82, 83, 84, and 85, on which the connection pins 86 are fixed, are fixed to the upper surface of the main body 21 of the cooling device 20.

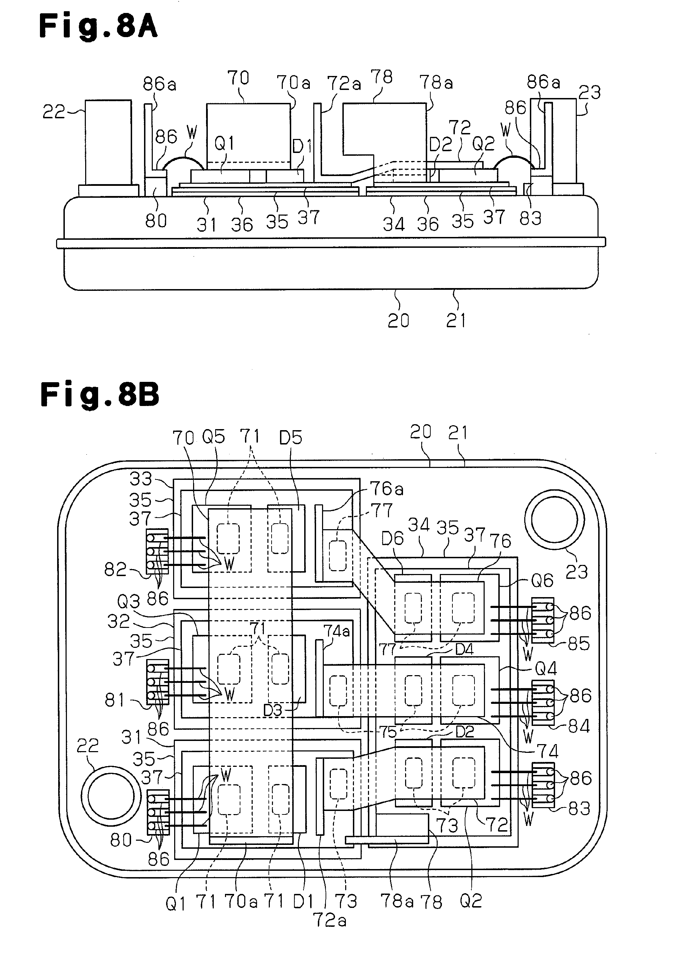

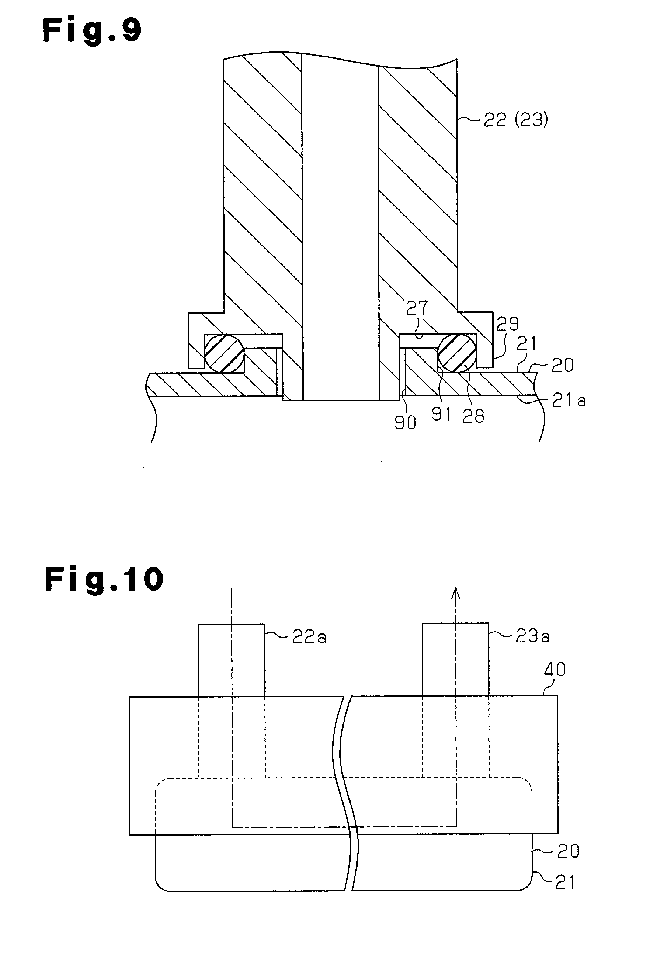

Referring to Figs. 8A and 8B, the connection pins 86 are joined with the corresponding transistors (chips) Q1, Q2, Q3, Q4, Q5, and Q6 by the wire W. Subsequently, the inlet pipe 22 and the outlet pipe 23 are mounted on the main body 21 of the cooling device 20. In detail, referring to Fig. 9, the O-ring 28 is held between the main body 21 and the lower end of each of the inlet pipe 22 and outlet pipe 23. In this state, the inlet pipe 22 and the outlet pipe 23 are arranged upright on the main body 21 of the cooling device 20.

As shown in Figs. 1A to 2B, the resin portion 40 is used to seal and integrate the components mounted on the main body 21 of the cooling device 20. The components mounted on the main body 21 of the cooling device 20 include the portion where the main body 21 and the inlet pipe 22 are coupled, the portion where the main body 21 and the outlet pipe 23 are coupled, the insulating substrates 31, 32, 33, and 34, the transistors Q1, Q2, Q3, Q4, Q5, and Q6, the diodes D1, D2, D3, D4, D5, and D6, the conductive plates 70, 72, 74, 76, and 78, the connection pins 86, and the wire W. The resin portion 40 is molded at about 120°C. This fixes the inlet pipe 22 and the outlet pipe 23 to the main body 21 with the resin portion 40. Thus, the inlet pipe 22 and the outlet pipe 23 can be fixed to the main body 21 with the resin portion 40 at the same time as when sealing the semiconductor elements (the transistors Q1, Q2, Q3, Q4, Q5, and Q6 and the diodes D1, D2, D3, D4, D5, and D6), which are soldered, with the resin portion 40.

In this manner, after brazing the upper plate 24, the lower plate 25, the inner fins 26, and the insulating substrates (DBA substrates) 31, 32, 33, and 34, which form the main body 21 of the cooling device 20, the pipes 22 and 23 are fixed to the main body 21 when the main body 21 is resin-sealed. The resin-sealing is performed at the same time as when sealing the circuit components of the module (the transistors Q1 to Q6, the diodes D1 to D6, the conductive plates 72, 74, 76, and 78, the connection pins 86, and the wire W). Unlike when brazing the pipes 22 and 23 to the main body 21 of the cooling device 20, the pipes 22 and 23 can be exchanged with other pipes whenever necessary using the main body 21 of the cooling device 20 as a common part.

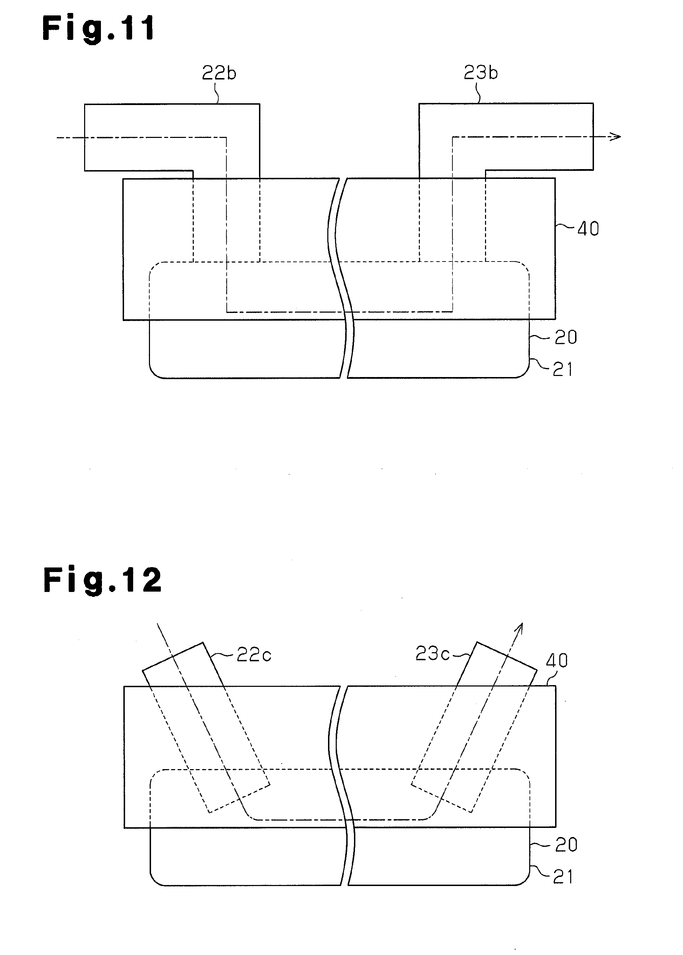

More specifically, as shown in Fig. 10, straight pipes 22a and 23a may be coupled to the main body 21 of the cooling device 20 and extended upright from the upper surface of the main body 21. Alternatively, as shown in Fig. 11, L-shaped pipes 22b and 23b may be coupled to the main body 21 so that the pipes 22b and 23b extend horizontally and in the longitudinal direction of the main body 21 of the cooling device 20.

As shown in Fig. 12, pipes 22c and 23c may be coupled to the main body 21 so that the pipes 22c and 23c extend diagonally relative to the upper surface of the main body 21 of the cooling device 20. More specifically, the upper longitudinal surface of the main body 21 is horizontal, and the pipes 22c and 23c are inclined relative to the upper surface of the main body 21.

The above embodiment has the advantages described below.
(1) The cooling device 20 includes the main body 21 and pipes (i.e., the inlet pipe 22 and the outlet pipe 23). The inlet pipe 22 is coupled to the main body 21 and supplies the coolant through the first port 90a, which is formed in the main body 21. The outlet pipe 23 is coupled to the main body 21 and discharges coolant through the second port 90b, which is formed in the main body 21. The resin portion 40 is molded onto a coupling portion, that is, the outer surface of the main body 21 where the pipes (i.e., the inlet pipe 22 and the outlet pipe 23) are coupled to the main body 21.

The conventional structure is susceptible to heat deformation that may occur in a brazing process. In contrast, the present embodiment molds the resin portion 40 subsequent to brazing. This prevents displacement of the inlet pipe 22 and the outlet pipe 23 that would be caused the heat generated during the brazing. In detail, the brazing is performed at about 600°C, whereas the resin molding is performed at about 120°C. Thus, in comparison with the convention structure, the structure of the present embodiment is less susceptible to heat deformation that would occur during the brazing.

In this manner, displacement of the pipes 22 and 23 relative to the main body 21 of the cooling device 20 caused by heat is prevented. As a result, the cooling device 20 can coupled the pipes 22 and 23 to the main body 21 while suppressing displacement of the pipes 22 and 23.

The conventional structure brazes and fixes coupled portions of a coolant passage. In contrast, the present embodiment increases flexibility at coupled portions of a coolant passage. Further, the inlet pipe 22 and the outlet pipe 23 are fixed to the main body 21 when resin-sealing the module components (i.e., the transistors Q1 to Q6, the diodes D1 to D6, the conductive plates 72, 74, 76, and 78, the connection pins 86, and the wire W). This reduces processing steps and allows for a decrease in the accuracy required for formation of the brazed components.
(2) The O-ring 28, which functions as a seal, is arranged between each pipe (i.e., the inlet pipe 22 and the outlet pipe 23) and the main body 21 to increase the seal between the pipe and main body 21. In particular, the O-ring 28 is used as the seal and thus provides superior sealing.
(3) The positioning part 91 and positioning part 29 for the O-ring 28 are formed on the pipes (i.e., the inlet pipe 22 and the outlet pipe 23) and the main body 21 at each portion where a pipe is coupled to the main body 21. This facilitates positioning of the O-ring 28.

It should be apparent to those skilled in the art that the present invention may be embodied in many other specific forms without departing from the spirit or scope of the invention. Particularly, it should be understood that the present invention may be embodied in the following forms.

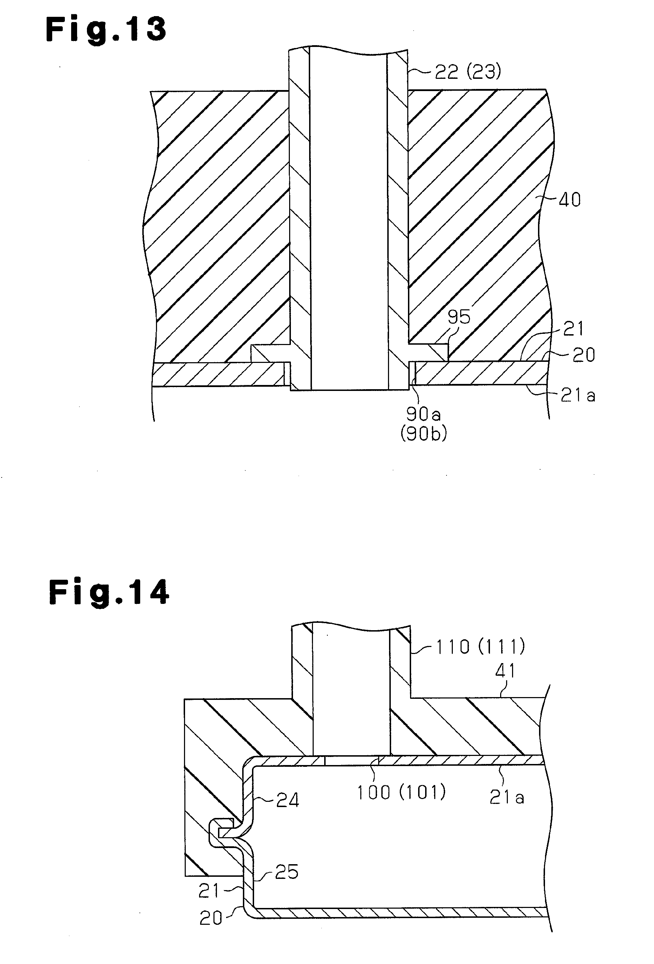

Referring to Fig. 13; a structure coupling the main body 21 of the cooling device 20 and the pipe 22 (23) does not need an O-ring. Instead, a flange 95 arranged on the pipe 22 (23) may be held in contact with the top panel 21a of the main body 21, and the resin portion 40 may seal the surrounding of the flange 95 and the top panel 21a.

As shown in Fig. 14, pipes 110 and 111 may be formed integrally with a resin portion 41. More specifically, a first port 100 and a second port 101 are formed in the top panel 21a of the main body 21 of the cooling device 20. The pipes 110 and 111 are simultaneously formed when the resin portion 41 is molded. The first port 100 is in communication with the inlet pipe 110, and the second port 101 is in communication with the outlet pipe 111.

In this manner, the resin portion 41 may be molded on the outer surface of the main body 21 around the ports formed in the main body 21 (around the first port 100 and second port 101). At the same time, the pipes (i.e., the inlet pipe 110 in communication with the first port 100 and the outlet pipe 111 in communication with the second port 101) may be formed integrally with the resin portion 41.

In this case, the resin portion 41 is molded after brazing is performed. This prevents the inlet pipe 110 and the outlet pipe 111 (i.e., coolant inlet and outlet) from being deformed by the heat generated in the brazing process. This prevents deformation of the pipes. In detail, the pipes 110 and 111 are not susceptible to heat deformation because they are coupled to the main body 21 after the upper plate 24, the lower plate 25, and the undulated inner fins 26 are brazed together (refer to Fig. 6) and the insulating substrates 31, 32, 33, and 34 are brazed to the main body 21 of the cooling device. This prevents displacement of the pipes 110 and 111 relative to the main body 21 of the cooling device 20 that would be caused by heat. As a result, the pipes 110 and 111 can be coupled to the main body 21 without being displaced. This structure also reduces the number of components.

Although the inlet pipe 22 and the outlet pipe 23 are formed from resin, the pipes may be formed from other materials.

Although the insulating substrates 31, 32, 33, and 34 are DBA substrates, the insulating substrates may be direct brazed copper (DBC) substrates, each including a ceramic substrate 35 sandwiched by copper layers.

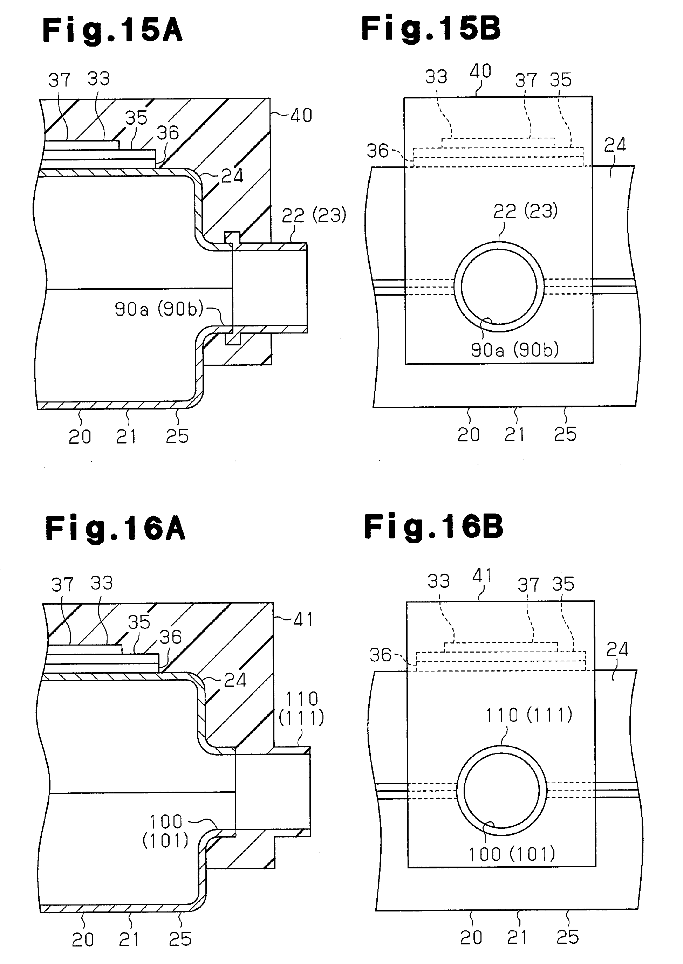

Although the ports (i.e., the first port 90a and the second port 90b) are formed in the upper plate 24 in Fig. 3, the ports may be formed in the lower plate 25. Further, as shown in Figs. 15A and 15B, the ports (i.e., the first port 90a and the second port 90b) may be formed between the upper plate 24 and the lower plate 25.

Although the ports (the first port 100 and the second port 101) are formed in the upper plate 24 in Fig. 14, the ports may be formed in the lower plate 25. As shown in Figs. 16A and 16B, the ports (i.e., the first port 100 and the second port 101) may be formed between the upper plate 24 and the lower plate 25.

Although the ports (i.e., the first port 100 and the second port 101) are formed in the upper plate 24 in Fig. 14, the first port 100 may be formed in the upper plate 24, and the second port 101 may be formed in the lower plate 25. Alternatively, the first port 100 may be formed in the lower plate 25, and the second port 101 may be formed in the upper plate 24.

It is only required that resin be molded over at least one of where the inlet pipe 22 is coupled to the main body 21 and where the outlet pipe 23 is coupled and the main body 21 to fix the pipe to the main body 21. More specifically, for example, the inlet pipe 22 may be coupled to the main body 21 by performing resin molding, and the outlet pipe 23 may be brazed to the main body 21. Alternatively, the outlet pipe 23 may be coupled to the main body 21 by performing resin molding, and the inlet pipe 22 may be brazed to the main body 21.

Although the present invention is applied to an inverter that functions as a power conversion device, the invention may be applied to other types of power conversion device, such as a converter.

The present examples and embodiments are to be considered as illustrative and not restrictive, and the invention is not to be limited to the details given herein, but may be modified within the scope and equivalence of the appended claims.

A cooling device includes a main body, a pipe, and a resin portion. The main body includes a first shell plate and a second shell plate each having a peripheral portion. The first shell plate and the second shell plate are integrated together by brazing the peripheral portions, and the main body includes a coolant passage and a port. The pipe is coupled to the main body and allows for circulation of coolant in the coolant passage through the port. The resin portion is molded on an outer surface of the main body at where the pipe is coupled to the main body to fix the pipe to the main body.

## Claims

1. A cooling device **characterized by:**
a main body (21) including a first shell plate (24) and a second shell plate (25), each having a peripheral portion, wherein the first shell plate (24) and the second shell plate (25) are integrated together by brazing the peripheral portions, and the main body (21) includes a coolant passage (P1) and a port (100, 101);
a pipe (22, 22a, 22b, 22c, 23, 23a, 23b, 23c, 110, 111) coupled to the main body (21), wherein the pipe (22, 22a, 22b, 22c, 23, 23a, 23b, 23c, 110, 111) allows for circulation of coolant in the coolant passage (P1) through the port (100, 101); and
a resin portion molded on an outer surface of the main body (21) at where the pipe (22, 22a, 22b, 22c, 23, 23a, 23b, 23c, 110, 111) is coupled to the main body (21) to fix the pipe (22, 22a, 22b, 22c, 23, 23a, 23b, 23c, 110, 111) to the main body (21).

2. The cooling device according to claim 1, **characterized in that** the port (100, 101) is formed in at least one of the first shell plate (24) and the second shell plate (25).

3. The cooling device according to claim 1, **characterized in that** the port (100, 101) is formed between the first shell plate (24) and the second shell plate (25).

4. The cooling device according to any one of claims 1 to 3, **characterized by** a seal (28) arranged between the pipe (22, 22a, 22b, 22c, 23, 23a, 23b, 23c) and the main body (21).

5. The cooling device according to claim 4, **characterized in that** the main body (21) and the pipe (22, 22a, 22b, 22c, 23, 23a, 23b, 23c) each include a positioning part (29, 91) where the pipe (22, 22a, 22b, 22c, 23, 23a, 23b, 23c) is coupled to the main body (21), and the positioning part (29, 91) positions the seal (28).

6. The cooling device according to any one of claims 1 to 3, **characterized in that** the pipe (110, 111) is formed integrally with the main body (21).
